(19) Europäisches Patentamt / European Patent Office / Office européen des brevets

(11) **EP 2 818 450 B1**

(12) **EUROPEAN PATENT SPECIFICATION**

(45) Date of publication and mention
of the grant of the patent:
**08.11.2023 Bulletin 2023/45**

(21) Application number: **13751736.3**

(22) Date of filing: **19.02.2013**

(51) International Patent Classification (IPC):
**C01B 33/035** $^{(2006.01)}$    **C23C 16/24** $^{(2006.01)}$
**C23C 16/46** $^{(2006.01)}$

(52) Cooperative Patent Classification (CPC):
**C23C 16/46; C01B 33/035; C23C 16/24**

(86) International application number:
**PCT/JP2013/000892**

(87) International publication number:
**WO 2013/125207 (29.08.2013 Gazette 2013/35)**

(54) **POLYCRYSTALLINE SILICON ROD MANUFACTURING METHOD**

**HERSTELLUNGSVERFAHREN FÜR POLYKRISTALLINE SILICIUMSTÄBE**

**PROCÉDÉ DE FABRICATION D'UNE TIGE DE SILICIUM POLYCRISTALLIN**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **23.02.2012 JP 2012037150**

(43) Date of publication of application:
**31.12.2014 Bulletin 2015/01**

(73) Proprietor: **Shin-Etsu Chemical Co., Ltd.
Tokyo 100-0004 (JP)**

(72) Inventors:
• **NETSU, Shigeyoshi
Joetsu-shi
Niigata 942-8601 (JP)**
• **KUROSAWA, Yasushi
Joetsu-shi
Niigata 942-8601 (JP)**
• **HOSHINO, Naruhiro
Joetsu-shi
Niigata 942-8601 (JP)**

(74) Representative: **Forrest, Stuart et al
WP Thompson
138 Fetter Lane
London EC4A 1BT (GB)**

(56) References cited:
JP-A- S6 374 909       JP-A- H01 305 810
JP-A- 2001 146 499    JP-A- 2002 508 294
US-B1- 6 221 155

• **Gonzalo Del ET AL: "UNIVERSIDAD POLITÉCNICA DE MADRID ESCUELA TÉCNICA SUPERIOR DE INGENIEROS DE TELECOMUNICACIÓN TESIS DOCTORAL CHEMICAL DECOMPOSITION OF SILANES FOR THE PRODUCTION OF SOLAR GRADE SILICON", , 24 November 2010 (2010-11-24), page 33-36,67,68,107,108,119-125, XP055222865, Retrieved from the Internet: URL:http://oa.upm.es/5153/1/GONZALO_COSO_S ANCHEZ.pdf [retrieved on 2015-10-22]**
• **DEL COSO ET AL: "Temperature homogeneity of polysilicon rods in a Siemens reactor", JOURNAL OF CRYSTAL GROWTH, ELSEVIER, AMSTERDAM, NL, vol. 299, no. 1, 1 February 2007 (2007-02-01), pages 165-170, XP005869991, ISSN: 0022-0248, DOI: 10.1016/J.JCRYSGRO.2006.12.004**

## Description

Technical Field

The present invention relates to a technology for manufacturing polycrystalline silicon rods to provide highly-pure polycrystalline silicon.

Background Art

Polycrystalline silicon is a raw material of single-crystal silicon substrates for manufacturing semiconductor devices and silicon substrates for manufacturing solar batteries. Generally, polycrystalline silicon is manufactured using the Siemens Method wherein a source gas containing chlorosilane is brought into contact with heated silicon cores, and polycrystalline silicon is deposited on surfaces of the silicon cores by the Chemical Vapor Deposition (CVD) Method.

When polycrystalline silicon is grown using the Siemens Method, two vertical silicon cores and one horizontal silicon core are assembled in a U-shape in a reacting furnace (reactor vessel), and each of ends of these U-shaped silicon cores is put into a core holder, subsequently these core holders are fixed on a pair of metal electrodes provided on a base plate. The silicon cores are heated by applying current through the U-shaped silicon cores via the metal electrodes and the silicon cores contact a source gas to deposit polycrystalline silicon, thus providing polycrystalline silicon rods. Note that, in a common reacting furnace, a plurality of sets of the U-shaped silicon cores is arranged on the base plate.

An internal space of a dome-shaped reaction container (bell jar) provided in the reacting furnace is sealed with the base plate and this sealed space is a reaction space for vapor-growing polycrystalline silicon. The metal electrodes for applying current through the U-shaped silicon cores have an insulator therebetween, penetrate through the base plate and are connected to a power source provided below the bell jar or to other metal electrodes for applying current through another U-shaped silicon cores arranged in the bell jar.

To prevent polycrystalline silicon from being deposited on areas other than the U-shaped silicon cores, and members making the reacting furnace from being damaged due to becoming an excessively high temperature state, the metal electrodes, the base plate and the bell jar are cooled with a cooling medium such as water. Note that the core holders are cooled through the metal electrodes.

When, for example, a mixed gas of trichlorosilane and hydrogen is used as the source gas for polycrystalline silicon deposition, in order to deposit polycrystalline silicon on the U-shaped silicon cores till a desired diameter is achieved, the surface temperature of the silicon cores has to be in the range of 900°C and 1300°C. Therefore, prior to the beginning of deposition reaction of polycrystalline silicon, the surface temperature of the silicon cores has to be raised to the range of 900°C and 1300°C, and to do so, current of 0.3 A/mm$^2$ to 4 A/mm$^2$ per cross-section area, generally, has to be applied to the silicon cores.

After polycrystalline silicon begins to be deposited, the amount of energization has to be so controlled that the surface temperature of the polycrystalline silicon rods is kept in the range of 900°C and 1300°C, as described above. Then, if the energization is performed using a commercial power frequency, i.e. 50 Hz or 60 Hz, as the diameter of the polycrystalline silicon rods becomes larger, the temperature difference obviously expands between in the central portions and on the side of the surfaces of the polycrystalline silicon rods. This tendency becomes stronger particularly when the diameter of the polycrystalline silicon rods exceeds 80 mm. It is because the central portions of the polycrystalline silicon rods are not specially cooled, but the polycrystalline silicon rods on the side of the surfaces are cooled through contact with the source gas supplied into the chamber.

Silicon crystals have a property that the higher their temperature is, the lower electric resistance becomes. Accordingly, the electric resistance of the central portions of the polycrystalline silicon rods in a relatively high temperature state becomes relatively low, and the electric resistance on the side of the surfaces of the polycrystalline silicon rods in a relatively low temperature state becomes relatively high. When such a distribution of the electric resistance arises inside the polycrystalline silicon rods, it becomes easy for the current supplied by the metal electrodes to flow through the central portions of the polycrystalline silicon rods, but it becomes difficult to flow on the side of the surfaces, accordingly, the temperature difference increasingly expands between in the central portions and on the side of the surfaces of the polycrystalline silicon rods.

When the growth in such a state continues and the diameter of the polycrystalline silicon rods becomes not less than 130 mm, the temperature difference between in the central portions and on the side of the surfaces becomes even not more than 150°C. Thus, if the temperature on the side of the surfaces, i.e. deposition surfaces of the polycrystalline silicon rods is kept in the range of 900°C and 1300°C, then the temperature of the central portions becomes too high, and at worst, the central portions may partially melt, resulting in a trouble such as a collapse of the silicon cores.

In view of these problems, Japanese Patent Laid-Open No. 63-74909 (Patent Literature 1) proposes the method in which a relatively more amount of current is applied near surfaces of polycrystalline silicon rods by utilizing a skin effect caused by a high-frequency current.

Further, National Publication of International Patent Application No. 2002-508294 (Patent Literature 2) reports the effort to reduce the temperature difference between in the central portions and on the side of the surfaces of polycrystalline silicon rods by using monosilane having a lower reaction temperature than that of chlorosilane as a source gas, setting a deposition temperature of polycrystalline silicon to about 850°C and using a high-frequency current having a frequency of 200 kHz to electrically heat, and the achievement that the polycrystalline silicon rods were able to be provided whose diameter reached 300 mm and which had stresses not more than 11 MP throughout the volume.

US6221155B1 (Patent Literature 4) discloses processes and a reactor apparatus for rapidly producing large diameter, high-purity polycrystalline silicon rods for semiconductor applications, by thermal decomposition of a highly refined silane or halosilane gas via chemical vapor deposition (CVD) on the surfaces of heated silicon rods in a reaction vessel. One or more low frequency power supply and/or a high frequency power supply can be used to provide A.C. current to silicon rods, at a frequency of 60 Hz and/or in the range of about 2 kHz to 800 kHz, respectively. The low frequency power supply may be used to heat the desired silicon deposition surface above a temperature of 200°C, and can then be adjusted to provide a temperature in the range of 600°C to 1200°C. The high frequency power supply can then be used to apply a high frequency current to maintain the temperature of the deposition surfaces, and such that at least about 70% of the current is concentrated on the outside of the rods in order to grow silicon rods up to 150 mm in diameter by CVD. When the rods reach a size of 150 mm in diameter, the power supply is de-energized and the rods are allowed to cool.

Citation List

Patent Literature

Patent Literature 1: Japanese Patent Laid-Open No. 63-74909
Patent Literature 2: National Publication of International Patent Application No. 2002-508294
Patent Literature 3: Japanese Patent Laid-Open No. 55-15999
Patent Literature 4: US Patent US6221155B1

Summary of Invention

Technical Problem

To control, during crystal growth, a temperature difference arising between on the side of the surfaces and in the central portions of polycrystalline silicon rods, it is effective to utilize the skin effect caused by applying a high-frequency current to electrically heat the polycrystalline silicon rods, as disclosed in above Patent Literatures. However, when a plurality of U-shaped silicon cores is set in one bell jar and the CVD reaction is performed by using such a high-frequency current in a system, the following problems occur.

If a high-frequency current power source is provided for each of a plurality of U-shaped silicon cores even when the plurality of the U-shaped silicon cores is set in a bell jar, then the achievement described in Patent Literature 1 or 2 can be provided. However, if such a configuration is used, it is required to provide the same number of high-frequency current power sources as the number of the U-shaped silicon cores, resulting in a complicated system configuration and a disadvantage in cost.

On the other hand, if a plurality of U-shaped silicon cores is energized by a single high-frequency current power source, a high voltage is required. In such a case, the plurality of U-shaped silicon cores is usually connected to each other in parallel, and the skin effect by high-frequency current occurs not only in polycrystalline silicon rods, but in conducting wires used for the above parallel connection. This fact may have escaped the attention in Patent Literature 1 or 2, and the skin effect arising in the conducting wires causes a large amount of current to flow in a part of a current pathway connecting the high-frequency current power source to the U-shaped silicon cores, resulting a partial heat generation, or the like.

Also, Patent Literature 2 uses monosilane as a source gas even if trichlorosilane is usually used as the source gas, and in this case, deposition temperature is between 900°C and 1300°C as described above, and it is required to electrically heat polycrystalline silicon rods to a higher temperature.

The inventors, according to the method disclosed in Patent Literature 2, tried an experiment in which trichlorosilane was used as a source gas, the surface temperature was raised to about 1000°C by applying current having a frequency of 200 kHz through polycrystalline silicon rods, and found that, in many cases, when the diameter of the polycrystalline silicon rods exceeded 160 mm, or from about then, polycrystalline silicon rods assembled in a U-shape began to collapse. Such a collapse of the polycrystalline silicon rods may be considered to come from the temperature difference between on the side of the surfaces and in the central portions, and we further tried an experiment wherein, to improve the skin effect, the frequency of current was further increased, and found that collapses of the polycrystalline silicon rods occurred rather more times.

The present invention has been made in view of the problems of the traditional methods, and its object is to provide a technology by which polycrystalline silicon rods having a large diameter can be manufactured with a high efficiency while using silane compounds such as chlorosilanes, particularly trichlorosilane as a raw material, and preventing a collapse of polycrystalline silicon rods easily occurring on manufacturing the polycrystalline silicon rods.

Solution to Problem

To solve the above problems, the present invention relating to a polycrystalline silicon rod manufacturing method includes a configuration described below.

According to the invention, there is provided a polycrystalline silicon rod manufacturing method wherein m silicon cores, m being an integer of 2 or greater, are arranged in a reactor vessel, a source gas containing trichlorosilane is supplied into the reactor vessel, and polycrystalline silicon is deposited on the silicon cores electrically heated using a CVD method, to obtain polycrystalline silicon rods having a diameter not less than 160mm, the method comprising a high-frequency current applying process for heating the polycrystalline silicon rods by applying through the polycrystalline silicon rods a current having a frequency of not less than 2 kHz, wherein the high-frequency current applying process comprises supplying a high-frequency current from one high-frequency power source supplying a single high-frequency current to n polycrystalline silicon rods, n being an integer of 2 or greater and not more than m, connected to each other in series whose diameter reaches a predetermined value $D_0$ of not less than 80mm due to the deposition of polycrystalline silicon, and a frequency of the high-frequency current is set so that a skin depth at which the high-frequency current flows through the n series-connected polycrystalline silicon rods takes a desired value in the range of not less than 13.8 mm and not more than 80.0 mm, wherein a surface temperature of the polycrystalline silicon rods is controlled in a range of not less than 900°C and not more than 1250°C to deposit polycrystalline silicon; the method further comprising: a process to heat the silicon cores by applying a current through the silicon cores before the high-frequency current applying process, and a process to commence a deposition of polycrystalline silicon on surfaces of the silicon cores after the surfaces of the silicon cores become a desired temperature; and wherein the m silicon cores are connected to each other in parallel before the process to heat the silicon cores, then current from one low-frequency power source supplies a low-frequency current to the m silicon cores, and when the diameter of the m polycrystalline silicon rods reaches the predetermined value $D_0$, the m polycrystalline silicon rods are switched to be connected to each other in series, and the high-frequency current applying process is performed by supplying the high-frequency current from the one high-frequency power source.

Also disclosed is a polycrystalline silicon rod manufacturing method wherein m silicon cores (m is an integer of 2 or greater) are arranged in a reactor vessel, a source gas containing

trichlorosilane is supplied into the reactor vessel, and polycrystalline silicon is deposited on the silicon cores electrically heated using a CVD method, the method including a high-frequency current applying process for heating the polycrystalline silicon rods by applying through the polycrystalline silicon rods a current having a frequency of not less than 2 kHz,

wherein the high-frequency current applying process includes supplying n polycrystalline silicon rods (n is an integer of 2 or greater and not more than m) connected to each other in series whose diameter reaches a predetermined value $D_0$ of not less than 80 mm due to the deposition of polycrystalline silicon, with a high-frequency current from one high-frequency power source supplying a single high-frequency current, and

the frequency of the high-frequency current is controlled so that skin depth at which the high-frequency current flows through then series-connected polycrystalline silicon rods takes a desired value in the range of not less than 13.8 mm and not more than 80.0 mm.

In the polycrystalline silicon rod manufacturing method according to the present invention, the silicon cores are heated

by applying a low-frequency current or a high-frequency current, and after the surfaces of the silicon cores become a desired temperature, the polycrystalline silicon deposition is commenced.

At this time, the m silicon cores are connected to each other in parallel, and the current from one low-frequency power source supplies a low-frequency current to the m silicon cores. This may begin to electrically heat the silicon cores.

Once the diameter of the m polycrystalline silicon rods reaches the predetermined value, the m silicon cores are switched to be connected to each other in series in order from a first one to an m-th, and the silicon cores may begin to

be electrically heated by supplying the series-connected silicon cores with current from the one high-frequency power source.

In the polycrystalline silicon rod manufacturing method according to the present invention, the m silicon cores are connected to each other in parallel, and from when the polycrystalline silicon begins to be deposited until the diameter of the polycrystalline silicon rods reaches the predetermined value $D_0$, the polycrystalline silicon rods may be electrically heated by supplying the parallel-connected polycrystalline silicon rods with current from one low-frequency power source supplying a low-frequency current.

Further, in a further aspect of the polycrystalline manufacturing method according to the present invention, M silicon cores (M is an integer of 2 or greater) may be further arranged in the reactor vessel, and polycrystalline silicon may be deposited on the M silicon cores in a similar manner as that for depositing polycrystalline silicon on the m silicon cores, using one high-frequency power source provided separately from the one high-frequency power source and supplying a single high-frequency current having a frequency of not less than 2 kHz.

Furthermore, in the polycrystalline silicon rod manufacturing method according to the present invention, a gas containing trichlorosilane is selected as the source gas, and the surface temperature of the polycrystalline silicon rods is controlled in the range of not less than 900°C and not more than 1250°C to deposit polycrystalline silicon.

Advantageous Effects of Invention

The present invention provides technology for manufacturing polycrystalline silicon rods having a large diameter with a high efficiency while using trichlorosilane and preventing a collapse easily arising on manufacturing polycrystalline silicon rods having a large diameter.

Brief Description of Drawings

[Figure 1] Figure 1 is a schematic, cross-sectional view showing one example of a configuration of a reacting furnace used when polycrystalline silicon rods are manufactured according to the present invention.

[Figure 2] Figure 2 is a block diagram for illustrating a configuration of a variable-frequency, high-frequency power source supplying current having a frequency of not less than 2 kHz used in the present invention.

[Figure 3A] Figure 3A is a block diagram showing a first example of a circuit connecting silicon cores to each other in parallel when three pairs of the silicon cores are arranged.

[Figure 3B] Figure 3B is a block diagram showing a first example of a circuit connecting silicon cores to each other in series when three pairs of the silicon cores are arranged.

[Figure 4A] Figure 4A is a block diagram showing a second example of a circuit connecting silicon cores to each other in parallel when three pairs of the silicon cores are arranged.

[Figure 4B] Figure 4B is a block diagram showing a second example of a circuit connecting silicon cores to each other in series when three pairs of the silicon cores are arranged.

[Figure 5A] Figure 5A is a block diagram showing a first example of a circuit connecting silicon cores to each other in parallel when two groups, each consisting of three pairs of the silicon cores, are arranged in a reacting furnace.

[Figure 5B] Figure 5B is a block diagram showing a first example of a circuit connecting silicon cores to each other in series when two groups, each consisting of three pairs of the silicon cores, are arranged in a reacting furnace.

[Figure 6A] Figure 6A is a block diagram showing a second example of a circuit connecting silicon cores to each other in parallel when two groups, each consisting of three pairs of the silicon cores, are arranged in a reacting furnace.

[Figure 6B] Figure 6B is a block diagram showing a second example of a circuit connecting silicon cores to each other in series when two groups, each consisting of three pairs of the silicon cores, are arranged in a reacting furnace.

[Figure 7A] Figure 7A shows a first example of an arrangement relation of a pair of metal electrodes, preferable for controlling a strong resistance caused by an inductive field.

[Figure 7B] Figure 7B shows a second example of an arrangement relation of a pair of metal electrodes, preferable for controlling a strong resistance caused by an inductive field.

[Figure 7C] Figure 7C shows a third example of an arrangement relation of a pair of metal electrodes, preferable for controlling a strong resistance caused by an inductive field.

[Figure 8A] Figure 8A shows a first example of an arrangement relation of a pair of metal electrodes, preferable for providing polycrystalline silicon rods having a cross-sectional shape with a high complete roundness.

[Figure 8B] Figure 8B shows a second example of an arrangement relation of a pair of metal electrodes, preferable for providing polycrystalline silicon rods having a cross-sectional shape with a high complete roundness.

[Figure 8C] Figure 8C shows a third example of an arrangement relation of a pair of metal electrodes, preferable for providing polycrystalline silicon rods having a cross-sectional shape with a high complete roundness.

[Figure 9] Figure 9 is a flowchart for illustrating an example of a manufacturing process of polycrystalline silicon rods according to the present invention.

[Figure 10A] Figure 10A is a view for illustrating a current distribution in a cross-section of a polycrystalline silicon rod having a diameter of 160 mm when current having a frequency of 80 kHz is applied through the polycrystalline silicon rod.

[Figure 10B] Figure 10B is a view for illustrating a relation between $I_X$ and $I_0$ of the current distribution ($I_X/I_0$) shown in Figure 10A.

[Figure 11] Figure 11 shows the result of the study of frequencies suitable for a high-frequency current used in the present invention.

[Figure 12A] Figure 12A is a view for illustrating a condition in which a crack occurs in a polycrystalline silicon rod.

[Figure 12B] Figure 12B is an enlarged view for illustrating a condition in which a crack occurs in a polycrystalline silicon rod.

[Figure 13] Figure 13 is a view for illustrating a current distribution in a cross-section of a polycrystalline silicon rod having a diameter of 160 mm when current having frequencies of 80 kHz and 200 kHz is applied through the polycrystalline silicon rod.

[Figure 14] Figure 14 is a flowchart for illustrating an example of a process for planning to expand the diameter of polycrystalline silicon rods by varying a frequency of a high-frequency current in response to change in an amount of energization.

Description of Embodiments

Now, embodiments of the present invention will be described below with reference to the drawings. Any drawings falling outside of the scope of the invention, which is defined by the appended claims, are provided for reference only.

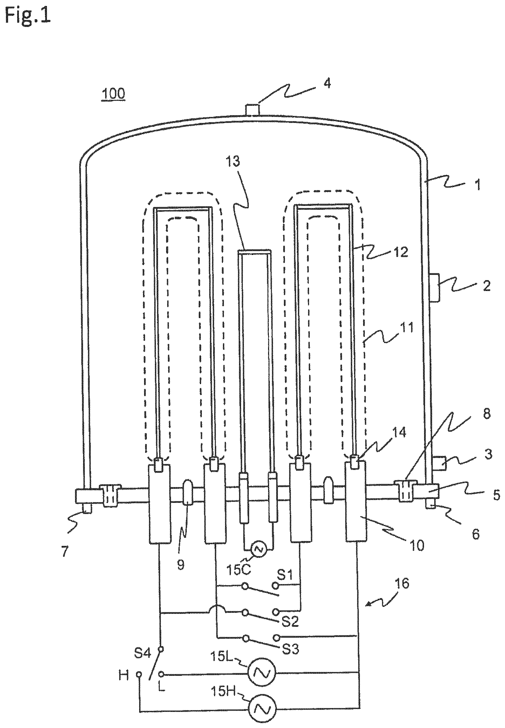

Figure 1 is a schematic, cross-sectional view illustrating one example of a configuration of a reacting furnace 100 used when polycrystalline silicon rods are manufactured according to the present invention. The reacting furnace 100 is a device in which polycrystalline silicon is vapor-grown on the surfaces of silicon cores 12 using the Siemens Method to provide polycrystalline silicon rods 11 and which includes a base plate 5 and a bell jar (chamber) 1.

The base plate 5 is provided with metal electrodes 10 supplying current to silicon cores 12, a source gas supply nozzle 9 supplying a process gas such as a nitrogen gas, a hydrogen gas and a trichlorosilane gas, and a reaction exhaust gas outlet 8 discharging an exhaust gas.

The bell jar 1 is provided with a cooling medium inlet 3 and a cooling medium outlet 4 for cooling this, and an observation window 2 for visually observing the inside of the bell jar 1. The base plate 5 is also provided with a cooling medium inlet 6 and a cooling medium outlet 7 for cooling this.

At the top of each of the metal electrodes 10, a core holder 14 made from carbon is provided to fix a silicon core 12. Figure 1 shows a state in which two pairs of silicon cores 12 assembled in a U-shape are arranged in the bell jar 1, but the number of pairs of silicon cores 12 is not limited to this number, and more than 2 pairs of a plurality of silicon cores 12 may be arranged. A circuit, in such an aspect, will be described below.

Between two pairs of silicon cores 12, a circuit 16 is arranged to connect these silicon cores to each other in series or in parallel. Switches S1 to S3 are provided to switch this circuit between a series configuration and a parallel configuration. In Particular, if the switch S1 is closed and the switches S2 and S3 are opened, then the two pairs of the U-shaped silicon cores 12 are connected to each other in series, and if the switch S1 is opened and the switches S2 and S3 are closed, then the two pairs of the U-shaped silicon cores 12 are connected to each other in parallel.

The circuit 16 is supplied with current from one low-frequency power source 15L supplying a low-frequency current (for example, current having a commercial frequency, that is, 50 Hz or 60 Hz), or from one high-frequency power source 15H supplying a high-frequency current having a single frequency of not less than 2 kHz. Note that a switch S4 switches between the low-frequency power source 15L and the high-frequency power source 15H.

Therefore, if the switch S1 is closed and the switches S2 and S3 are opened, so that the two pairs of the U-shaped silicon cores 12 (or the polycrystalline silicon rods 11) are connected to each other in series, and the switch S4 is switched to the side of the high-frequency power source 15H, then the series-connected U-shaped silicon cores 12 (or the polycrystalline silicon rods 11) can be electrically heated by supplying the silicon cores with a high-frequency current having a single frequency of not less than 2 kHz.

Also, from when polycrystalline silicon begins to be deposited until the diameter of the polycrystalline silicon rods 11 reaches a predetermined value $D_0$, the parallel-connected polycrystalline silicon rods may be supplied with current from the low-frequency power source 15, and subsequently, the polycrystalline silicon rods 11 may be reconnected to each other in series and supplied with current from the high-frequency power source 15H.

Note that if more than two pairs of the U-shaped silicon cores 12 are arranged, then the U-shaped silicon cores 12 (or the polycrystalline silicon rods 11) may be also connected to each other in series in sequence.

Figure 1 shows a carbon heater 13 that is supplied with power from a power source 15C to radiatively heat the surfaces of the silicon cores 12 for the purpose of initially heating the silicon cores 12 prior to the beginning of deposition reaction of polycrystalline silicon. This carbon heater 13 is provided for the purpose of reducing resistance of the silicon cores 12 by radiative heating, thereby controlling a voltage applied to the silicon cores 12 to be lower during initial energization. In an aspect, instead of, or in addition to such a carbon heater 13, the low-frequency power source 15L or the high-frequency power source 15H may be used. For example, electrical heating can be carried out, such as by connecting the silicon cores 12 to each other in parallel and supplying the current from the low-frequency power source 15L, by connecting the silicon cores 12 to each other in series in sequence and supplying the silicon cores 12 with the current from the low-frequency power source 15L, or further by connecting the silicon cores 12 to each other in series in sequence and supplying the silicon cores 12 with the current from high-frequency power source 15H.

In the example shown in Figure 1, the high-frequency power source 15H is used as a power source for supplying the high-frequency current having a single frequency of not less than 2 kHz, but it may be a variable-frequency, high-frequency power source supplying current having a frequency of not less than 2 kHz. In this case, the variable-frequency, high-frequency power source may be capable of continuously changing the frequency or changing between a plurality of levels.

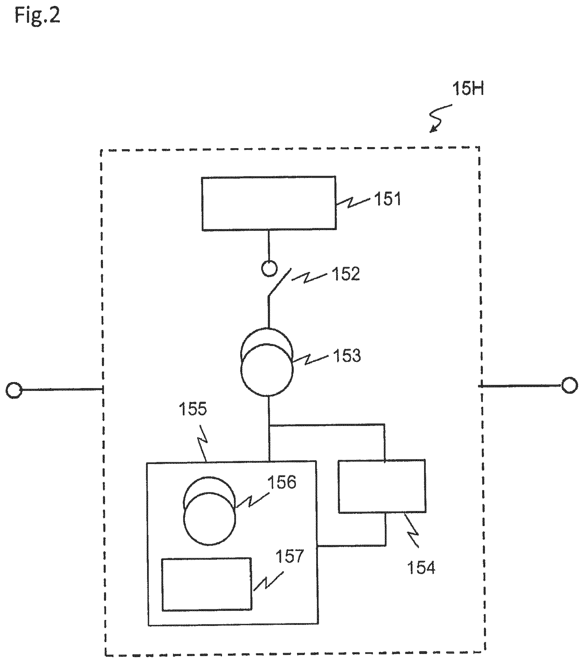

Figure 2 is a block diagram for illustrating an example of a configuration of such a variable-frequency, high-frequency power source 15H, and in Figure 1, a power receiving component 151, an air circuit breaker (ACB) 152, a power source transformer 153, an output control component 154, an output component 155, an output transformer 156 and a frequency converter 157 are shown. Using such a variable-frequency, high-frequency power source 15H facilitates controlling the skin depth as a function of the diameter of the polycrystalline silicon rods by changing the frequency of a high-frequency current supplied to polycrystalline silicon rods in response to variation in surface temperature of the polycrystalline silicon rods.

In the aspect shown in Figure 1, the two pairs of the silicon cores 12 assembled in a U-shape are arranged in the bell jar 1, but more than two pairs of a plurality of silicon cores 12 may be arranged.

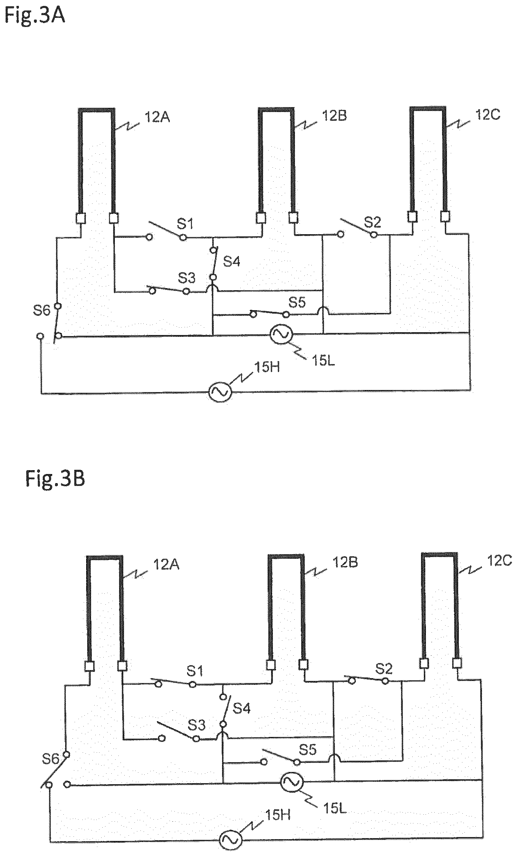

Figures 3A and 3B are block diagrams illustrating a first example of a circuit connecting silicon cores 12A to C to each other when three pairs of silicon cores 12 are arranged.

In an aspect shown in Figure 3A, a circuit includes 6 switches (S1 to S6), and if the switches S1 and S2 are opened and the switches S3, S4 and S5 are closed, then the 3 pairs of the silicon cores 12A to C are connected to each other in parallel, and the switch S6 is switched to the side of the low-frequency power source 15L, so that the above parallel connection circuit is supplied with current. Also, if the switches S1 and S2 are closed and the switches S3, S4 and S5 are opened, then a series connection state is configured in which the low-frequency power source 15L supplies current.

In an aspect shown in Figure 3B, switches S1 and S2 are closed, switches S3, S4 and S5 are opened, accordingly the 3 pairs of the silicon cores 12A to C are connected to each other in series, and a switch S6 is switched to the side of the high-frequency power source 15H, so that the above series connection circuit is supplied with current.

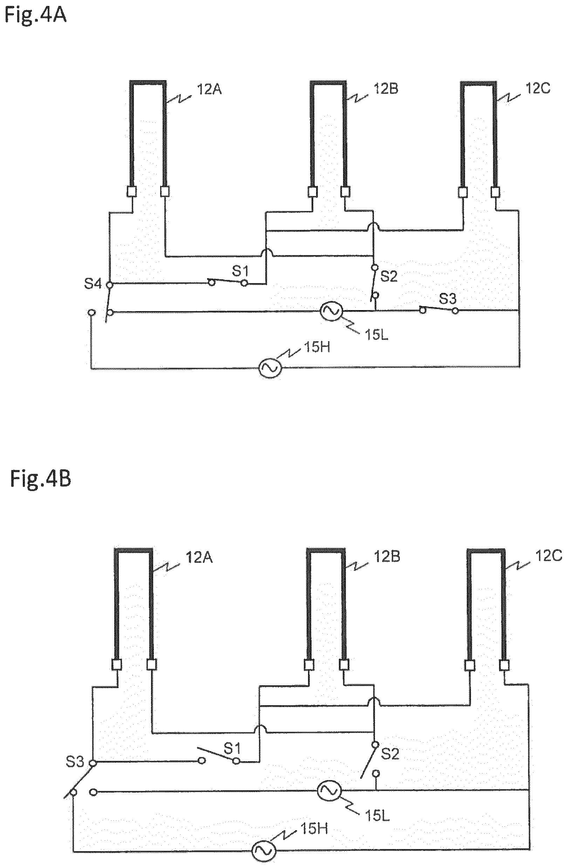

Figures 4A and 4B are block diagrams illustrating a second example of a circuit for connecting silicon cores 12A to C to each other when 3 pairs of the silicon cores 12 are arranged.

In an aspect shown in Figure 4A, a circuit includes 3 switches (S1 to S3), the switches S1, S2 and S3 are closed, accordingly the 3 pairs of the silicon cores 12A to C are connected to each other in parallel, and the switch S4 is switched to the side of the low-frequency power source 15L, so that the above parallel connection circuit is supplied with current. Also, from these conditions, opening the switches S1 and S2 causes the low-frequency power source 15L to supply the current in a series connection.

In an aspect shown in Figure 4B, switches S1 and S2 are opened, accordingly the 3 pairs of the silicon cores 12A to C are connected to each other in series, and a switch S3 is switched to the side of the high-frequency power source 15H, so that the above series connection circuit is supplied with current.

In another aspect, in addition to the plurality of silicon cores (m silicon cores, m is an integer of 2 or greater) constituting a group (first group) having the connection relation as described above, a plurality of silicon cores (M silicon cores, M is an integer of 2 or greater) constituting another group (second group) may be provided in the same reacting furnace.

That is, in addition to the m silicon cores composing the first group, the M silicon cores composing the second group may be further arranged in the reactor vessel, and a high-frequency power source associated with the second group supplying current of a frequency of not less than 2 kHz may be provided separately from the high-frequency power source associated with the first group above, and polycrystalline silicon may be deposited on the M silicon cores composing the second group above in a similar manner as that of the deposition of polycrystalline silicon on the silicon cores composing the first group above.

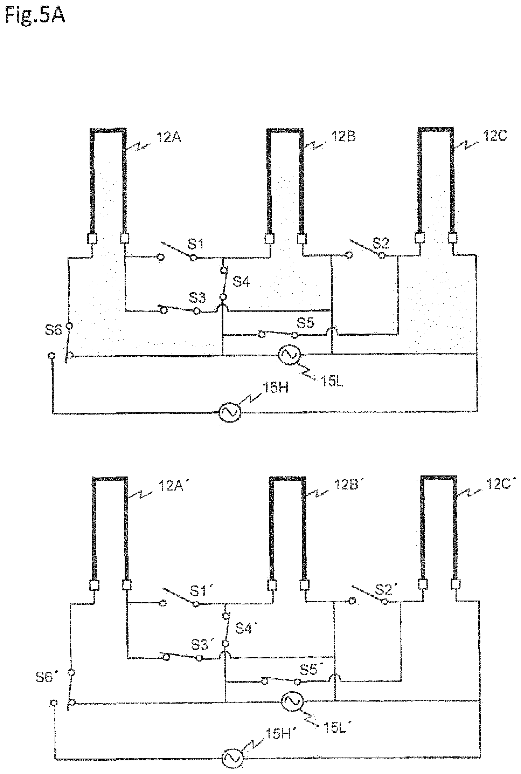

Figure 5A is a block diagram showing a first example of a circuit connecting silicon cores to each other in parallel when 2 groups (m=3, M=3), each including 3 pairs of the silicon cores, are arranged in the reacting furnace. Similar to the aspect shown in Figure 3A, in every group, a circuit includes 6 switches (S1 to S6, S1' to S6'), the switches S1 and S2, and S1' and S2' are opened, the switches S3, S4 and S5, and S3', S4' and S5' are closed, so that the 3 pairs of the silicon cores 12A to C, and 12A' to C' are connected to each other in parallel, and the switches S6, S6' are switched to the side of the low-frequency power sources 15L, 15L', accordingly the above parallel connection circuit is supplied with current.

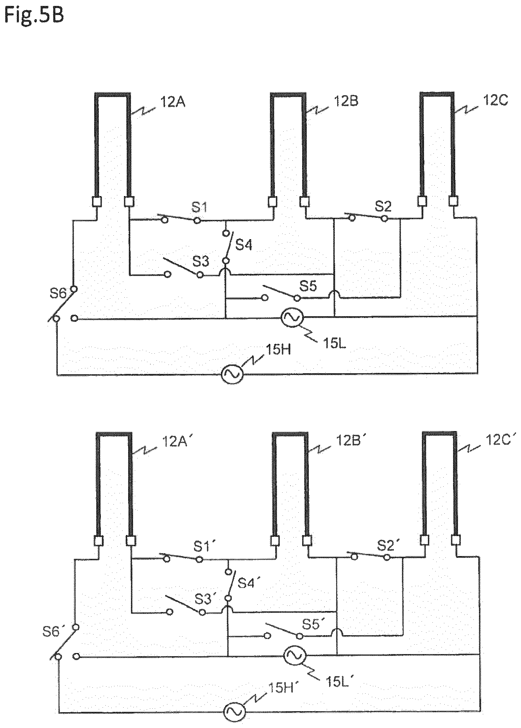

Figure 5B is a block diagram showing a first example of a circuit connecting silicon cores to each other in series when 2 groups (m=3, M=3), each including 3 pairs of the silicon cores, are arranged in the reacting furnace. Similar to the aspect shown in Figure 3B, in every group, switches S1 and S2, and S1' and S2' are closed, accordingly the 3 pairs of the silicon cores 12A to C and 12A' to C' are connected to each other in series, and switches S6, S6' are switched to the side of the high-frequency power sources 15H, 15H', so that the above series connection circuit is supplied with current.

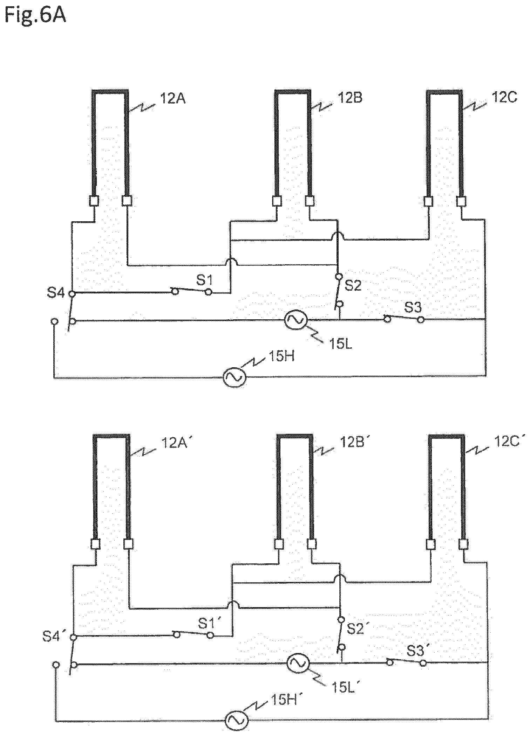

Figure 6A is a block diagram showing a second example of a circuit connecting silicon cores to each other in parallel when 2 groups (m=3, M=3), each including 3 pairs of the silicon cores, are arranged in the reacting furnace. Similar to the aspect shown in Figure 4A, in every group, switches S1, S2 and S3, and S1', S2' and S3' are closed, the 3 pairs of the silicon cores 12A to C and 12A' to C' are connected to each other in parallel, and switches S4, S4' are switched to the side of the low-frequency power sources 15L, 15L', so that the above parallel connection circuit is supplied with current.

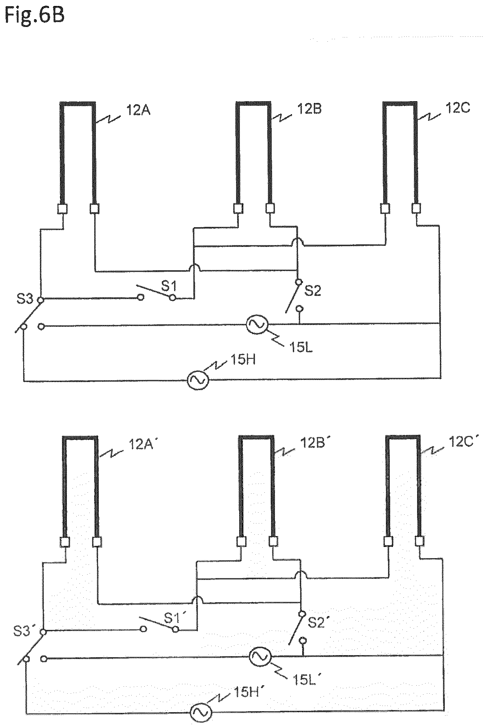

Figure 6B is a block diagram showing a second example of a circuit connecting silicon cores to each other in a series when 2 groups (m=3, M=3), each including 3 pairs of the silicon cores, are arranged in the reacting furnace. Similar to the aspect shown in Figure 4B, in every group, switches S1 and S2, and S1' and S2' are opened, accordingly the 3 pairs of the silicon cores 12A to C and 12A' to C' are connected to each other in series, and switches S3, S3' are switched to the side of the high-frequency power sources 15H, 15H', so that the above series connection circuit is supplied with current.

According to an aspect, a reaction system configured in a way as described above is used, more than 1 silicon cores are arranged in the reactor vessel, the source gas containing trichlorosilane is supplied into the reacting furnace, and polycrystalline silicon is deposited on the silicon cores electrically heated using the CVD method to manufacture polycrystalline silicon rods. And, in the process for manufacturing polycrystalline silicon, a high-frequency current applying process is provided in which polycrystalline silicon rods are heated by applying through the polycrystalline silicon rods a current having a frequency of not less than 2 kHz, and the skin effect caused by a high-frequency current is suitably used to prevent the polycrystalline silicon rods from being locally, abnormally heated, thereby allowing polycrystalline silicon rods having a large diameter to be stably manufactured.

Note that as the power source supplying the high-frequency current having a frequency of not less than 2 kHz, any power source may be used which supplies a single high-frequency current, or whose frequency is variable, as described above.

Although details will be described below, if a high-frequency power source supplying a single high-frequency current is used, the polycrystalline silicon rod manufacturing method according to the present invention can include a configuration described below.

In the polycrystalline silicon rod manufacturing method according to the present invention, in a process in which m silicon cores (m is an integer of 2 or greater) are arranged in the reactor vessel, a source gas containing trichlorosilane is supplied into the reacting furnace, and polycrystalline silicon is deposited on the silicon cores electrically heated using the CVD method to manufacture polycrystalline silicon rods, a high-frequency current applying process is provided in which the polycrystalline silicon rods are heated by applying through the polycrystalline silicon rods a current having a frequency of not less than 2 kHz. This high-frequency current applying process includes supplying n polycrystalline silicon rods (n is an integer of 2 or greater and not more than m) connected to each other in series whose diameter reaches a predetermined value $D_0$ of not less than 80 mm due to the deposition of polycrystalline silicon, with a high-frequency current from one high-frequency power source supplying a single high-frequency current, and the frequency of the high-frequency current is set so that the skin depth at which the high-frequency current flows through the n series-connected polycrystalline silicon rods takes a desired value in the range of not less than 13.8 mm and not more than 80.0 mm.

If a variable-frequency, high-frequency power source is used, the polycrystalline silicon rod manufacturing method according to the present invention may include a configuration described below.

In a process in which silicon cores are arranged in the reactor vessel, a source gas containing trichlorosilane is supplied into the reacting furnace, and polycrystalline silicon is deposited on the silicon cores electrically heated using the CVD method to manufacture polycrystalline silicon rods, a high-frequency current applying process is provided in which the polycrystalline silicon rods are heated by applying through the polycrystalline silicon rods a current having a frequency of not less than 2 kHz. This high-frequency current applying process includes supplying a high-frequency current to the polycrystalline silicon rods whose diameter reaches a predetermined value $D_0$ of not less than 80 mm due to the deposition of polycrystalline silicon connected to each other in series. In the high-frequency current supplying process, the frequency of the high-frequency current is selected in response to variation in surface temperature of the polycrystalline silicon rods to the extent that the skin depth at which the high-frequency current flows through the polycrystalline silicon rods is in the range of not less than 13.8 mm and not more than 80.0 mm.

In every one of these aspects, the silicon cores may begin to be heated by applying the low-frequency current or the high-frequency current, and polycrystalline silicon may begin to be deposited after the surfaces of the silicon cores become a desired temperature.

At this time, m silicon cores may be connected to each other in parallel and the silicon cores may begin to be heated by supplying the parallel-connected silicon cores with current from one low-frequency power source supplying a low-frequency current.

Also, m silicon cores may be connected to each other in series in order from a first one to an m-th, and the silicon cores may begin to be heated by supplying the series-connected silicon cores with current from one high-frequency power source.

In the polycrystalline silicon rod manufacturing method according to the present invention, in an aspect, m polycrystalline silicon rods may be connected to each other in parallel, and from when the polycrystalline silicon rods begin to be deposited until the diameter of the polycrystalline silicon rods reaches the predetermined value $D_0$, the polycrystalline silicon rods may be heated by supplying the parallel-connected polycrystalline silicon rods with current from one low-frequency power source supplying a low-frequency current.

Also, in an aspect, M silicon cores (M is an integer of 2 or greater) may be further arranged in the reactor vessel, and by using a high-frequency power source provided separately from the one high-frequency power source and supplying a single high-frequency current having a frequency of not less than 2 kHz, or by using one variable-frequency, high-frequency power source supplying a current of a frequency of not less than 2 kHz, polycrystalline silicon may be deposited on the M silicon cores in a similar manner as that of the deposition of polycrystalline silicon on the m silicon cores.

Further, according to the present invention, a gas containing trichlorosilane is selected as the source gas, and the surface temperature of polycrystalline silicon rods is controlled in the range of not less than 900°C and not more than 1250°C to deposit polycrystalline silicon.

Note that the number of pairs of the electrodes 10 provided is the same as or less than the number of pairs of U-shaped silicon cores 12 arranged in the chamber 1, and preferably, these pairs of the metal electrodes 10 are arranged relative to each other so that a strong resistance is not produced from an inductive field formed by the U-shaped silicon cores 12 or the polycrystalline silicon rods 11 held in a pair of the metal electrodes adjacent to each other when a high-frequency current flows. Alternatively, adjusting the phase of a high-frequency current may control a strong resistance produced from an inductive field.

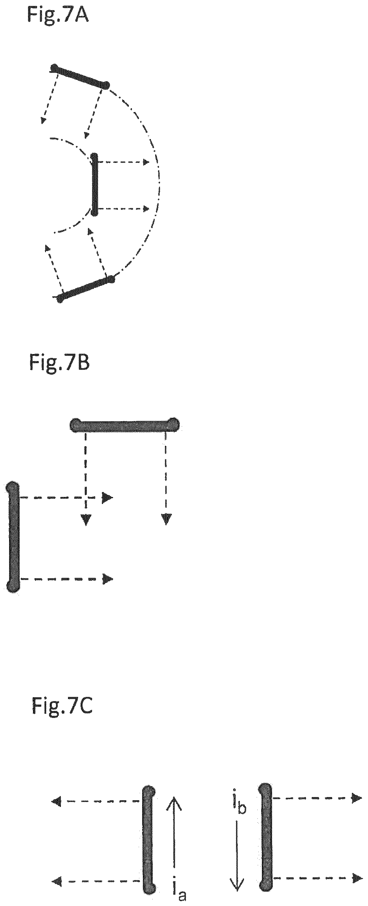

Figures 7A to C is a view for illustrating such an arrangement relation of pairs of metal electrodes, seen from above, and the arrows shown are the directions of magnetic fields formed by energization of silicon cores.

In an aspect shown in Figure 7A, a rectangular plane formed by 2 pillar sections of U-shaped silicon cores 12 and a beam section linking these pillar sections to each other is arranged so as not to be even partially opposed to another rectangular plane of the U-shaped silicon cores 12 adjacently arranged.

In an aspect shown in Figure 7B, a rectangular plane formed by 2 pillar sections of U-shaped silicon cores 12 and a beam section linking these pillar sections to each other is arranged orthogonally to another rectangular plane of the U-shaped silicon cores 12 adjacently arranged.

In an aspect shown in Figure 7C, a rectangular plane formed by 2 pillar sections of U-shaped silicon cores 12 and a beam section linking these pillar sections to each other is arranged parallel to another rectangular plane of the U-shaped silicon cores 12 adjacently arranged, and to these silicon cores 12, current ($i_a$, $i_b$) is applied that is phase-adjusted so that the direction of a magnetic field formed by each of the silicon cores 12 is opposite to each other.

Also, to provide polycrystalline silicon rods having a cross-section with a high complete roundness, preferably, silicon cores are arranged on concentric circles centering at the center of the base plate.

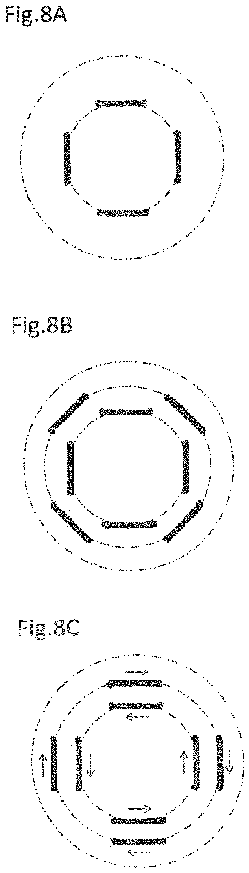

Figures 8A to C illustrate such an arrangement relation of pairs of metal electrodes, and dash lines shown are concentric circles centering at the center of the base plate.

In an aspect shown in Figure 8A, for example, 4 pairs of silicon cores 12 are arranged on the concentric circles above.

If many silicon cores 12 are arranged in the chamber, then, for example, 8 pairs of silicon cores 12 are preferably arranged on 2 concentric circles having different diameters, 4 pairs by 4 pairs. In an aspect shown in Figure 8B, the above rectangular plane of silicon cores 12 arranged on an inner concentric circle and another rectangular plane of nearby silicon cores 12 arranged on an outer concentric circle are arranged so as not to be even partially opposed to each other.

Also, in an aspect shown in Figure 8C, the above rectangular plane of silicon cores 12 arranged on an inner concentric circle and another rectangular plane of nearby silicon cores 12 arranged on an outer concentric circle are opposed to each other, but similarly as shown in Figure 7C, to these silicon cores 12, current ($i_a$, $i_b$) is applied that is phase-adjusted so that the direction of a magnetic field formed by each of the silicon cores 12 is opposite to each other.

Next, a polycrystalline silicon rod manufacturing process according to the present invention will be described.

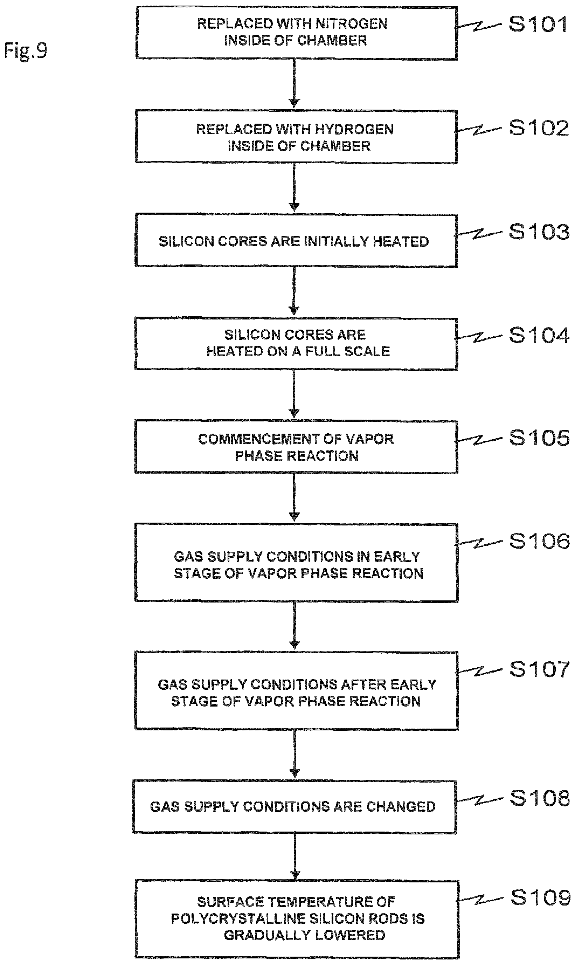

Figure 9 is a flowchart for illustrating an example of a polycrystalline silicon rod manufacturing process according to the present invention when the reacting furnace 100 having the configuration shown in Figure 1 is used.

First, a chamber 1 is mounted closely on a base plate 5, and a nitrogen gas is supplied from a source gas supply nozzle 9 into the chamber 1 to replace inside air with nitrogen (S101). Air and nitrogen inside the chamber 1 are discharged through an exhaust gas outlet 8 to the outside of the chamber 1. After replaced with nitrogen in the chamber 1, a hydrogen gas, instead of the nitrogen gas, is supplied from the source gas supply nozzle 9 to create a hydrogen environment in the chamber 1 (S102).

Next, silicon cores 12 are initially heated (preliminary heating) (S103). In the reacting furnace 100 having the configuration shown in Figure 1, for this initial heating, a carbon heater 13 is used, but a heated hydrogen gas may be supplied into the chamber 1. Due to this initial heating, the temperature of the silicon cores 12 is raised to not less than 300°C, and electric resistance of the silicon cores 12 takes such a value that energization can be efficiently performed.

Following that, power is supplied from the metal electrodes 10, and the silicon cores 12 are energized via core holders 14 to heat the silicon cores 12 to between about 900°C and 1300°C (main heating) (S104). Then, a mixed gas of a trichlorosilane gas containing silane compounds, i.e. the source gas with a hydrogen gas, i.e. a carrier gas is supplied into the chamber 1 at a relatively slow flow (flow rate), and polycrystalline silicon begins to be vapor-grown on the silicon cores 12 (S105). Also, the initial heating of the silicon cores may be performed in a nitrogen environment, and in this case, nitrogen has to be replaced with hydrogen before the trichlorosilane gas is supplied.

Generally, the silicon cores 12 are thin and have not a high, mechanical strength. Accordingly, in an early period of vapor growth reaction of polycrystalline silicon, an ejection pressure at which the supply gas is supplied into the chamber 1 easily causes a trouble, such as a collapse of the silicon cores 12. Thus, the supply gas flow (flow rate) in the early period of vapor growth reaction is preferably set to a relatively low level (S106).

On the other hand, to improve a yield constant by increasing a deposition rate (reaction rate) of polycrystalline silicon, it is necessary to keep high a bulk concentration of the source gas supplied into the chamber 1 (concentration of the source gas in the supply gas). In particular, the bulk concentration of the source gas (trichlorosilane) is preferably kept between not less than 15 mol % and not more than 40 mol % till the diameter of the polycrystalline silicon rods reaches at least 15 mm (preferably 20 mm).

Also, to increase the deposition rate, the supply gas flow (flow rate) is preferably raised to near the maximum value after there is not a risk of collapse of the silicon cores 12 (polycrystalline silicon rods 11), or the like (S107). Such a setting of the supply gas flow (flow rate) may be performed, for example, at the time when the diameter of the polycrystalline silicon rods 11 reaches 20 mm, but the value of 40 mm may be used as a target. Also, the gas is preferably supplied so that the pressure inside the chamber 1 is between 0.3 MPa and 0.9 MPa, and a flow rate at the exhaust outlet of the source gas supply nozzle 9 is preferably not less than 150 m/sec.

During this period, the surface temperature of the polycrystalline silicon rods 11 is preferably kept relatively high, i.e. not less than 1000°C, and for example, the temperature is controlled in the range of 1000°C and 1250°C.

As the diameter of the polycrystalline silicon rods further grows, a region where the source gas tends to accumulate will arise in the chamber 1. In such a condition, supplying the source gas containing silane compounds in a high concentration may cause a risk of occurrence of a large quantity of silicon fine particles, and these fine particles may adhere to the surfaces of the polycrystalline silicon rods 11 to provide a cause of contamination, or the like.

Accordingly, the bulk concentration of the source gas in the supply gas is preferably lowered till the diameter of the polycrystalline silicon rods 11 reaches 130 mm at the latest (S108). For example, the bulk concentration of the source gas (trichlorosilane) is lowered from a value in the range of not less than 30 mol % and not more than 50 mol % to a value in the range of not less than 15 mol % and not more than 45 mol %. Preferably, the bulk concentration of trichlorosilane is set between not less than 20 mol % and not more than 40 mol %.

And now, silicon crystal has a property that the higher its temperature is, the lower electric resistance becomes. Thus, if polycrystalline silicon rods are electrically heated using a power source having a commercial frequency, then the temperature in the central portions of the polycrystalline silicon rods becomes higher than that near the surfaces due to the electric heating and cooling near the surfaces when the diameter of the polycrystalline silicon rods becomes not less than a constant value. In this case, the electric resistance in the central portions of the polycrystalline silicon rods is lower compared to the electric resistance on the side of the surfaces, and this tendency becomes remarkable as the diameter expands.

Thus, current applied to polycrystalline silicon rods tends to flow through the central portions having a lower electric resistance, and a current density in the central portions more and more increases, while a current density on the side of the surfaces decreases, so that the temperature unevenness described above is increasingly amplified. For example, if polycrystalline silicon rods are heated so that the surface temperature thereof becomes not less than 1000°C, then the temperature difference between in the central portions and on the side of the surfaces is even not less than 150°C when the diameter is not less than 130 mm.

In contrast to this, a high-frequency current shows a skin effect, and if a conductor is energized, a current density near the surface becomes high, as described above. This skin effect becomes more remarkable as a frequency is high, and current tends to concentrate on a surface. Note that a depth at which current flows is called a "skin depth", or a "current penetration depth". The skin depth $\delta$ has the following relation with a frequency f of current, permeability $\mu$ of polycrystalline silicon and conductivity k of polycrystalline silicon:

$$\delta^{-1} = (\pi \cdot f \cdot \mu \cdot k)^{1/2}$$

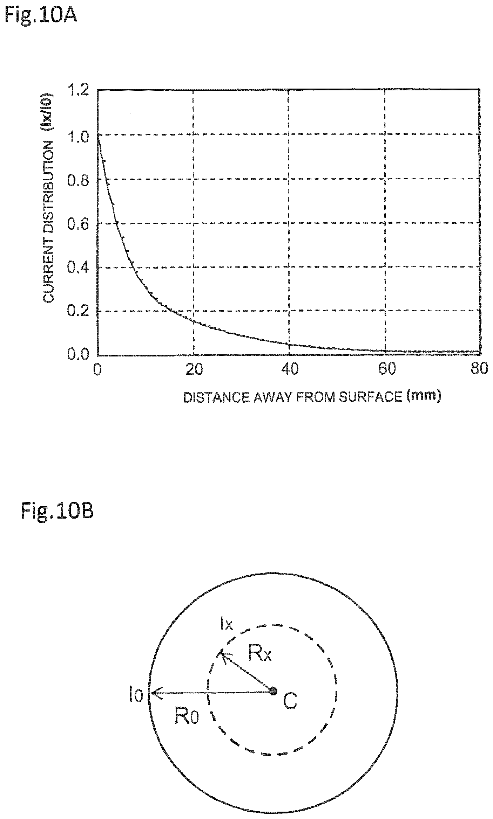

Figure 10A and Figure 10B are a view for illustrating a state of a current distribution in a cross-section and a view for illustrating the relation between $I_X$ and $I_0$ of the current distribution ($I_X/I_0$) when current having a frequency of 80 kHz is applied through a polycrystalline silicon rod having a diameter of 160 mm, respectively. The current distribution is normalized using a ratio of a value ($I_X$) of current flowing a region away by a radius $R_X$ from the center C of the polycrystalline silicon rod (radius, $R_0$=80 mm) to a value ($I_0$) of current flowing on the surface of the polycrystalline silicon rod.

As shown, applying a high-frequency current heats a polycrystalline silicon rod, thereby allowing a region near the surface to be preferentially heated, and thus, the region near the surface can be preferentially heated even if the radius of the polycrystalline silicon rod expands. Therefore, a temperature distribution inside polycrystalline silicon can be prevented from being expanded to the extent of damaging manufacturing.

Applying a high-frequency current in such a manner is preferably performed for a polycrystalline silicon rod whose diameter reaches a predetermined value $D_0$ of not less than 80 mm.

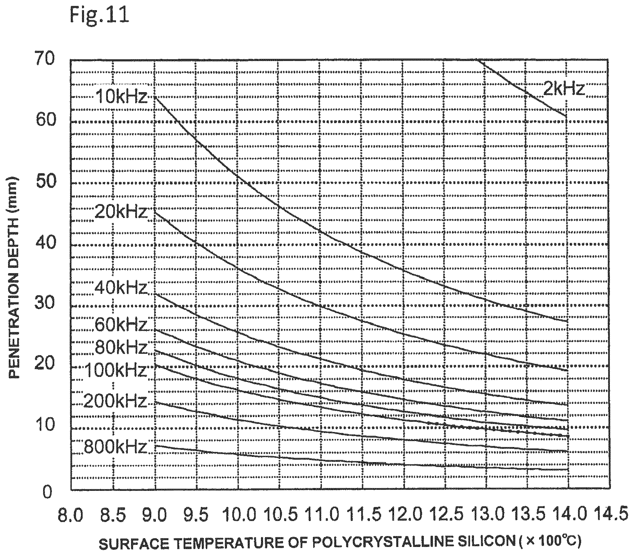

Figure 11 is a view showing the result of the study of frequencies suitable for a high-frequency current used in the present invention. Frequencies were studied from 2 kHz to 200 kHz. According to the result shown, if the frequency is 800 kHz and the surface temperature of the polycrystalline silicon rod is 1150°C, then the penetration depth $\delta$ is merely about 4 mm, and even if the temperature is 900°C, and the penetration depth $\delta$ is only about 7 mm. Also, if the frequency is 200 kHz and the surface temperature of the polycrystalline silicon rod is 1150°C, then the penetration depth $\delta$ is a little less than 9 mm, and even if the temperature is 900°C, it is only 13.7 mm.

If only such a shallow penetration depth is achieved, polycrystalline silicon will partially melt particularly due to concentration of the current density in a bend section of U-shaped silicon cores, and manufacturing may be damaged.

In an experiment the inventors performed, on trying to grow polycrystalline silicon rods by using trichlorosilane as a source gas and applying a high-frequency current of 200 kHz for electric heating, a trouble such as a collapse also occurred when the diameter of the polycrystalline silicon rods reached about 160 mm. Inventors confirmed cause of it and found that the polycrystalline silicon rods had a crack in a bend section (upper corner) of the silicon cores assembled in a U-shape.

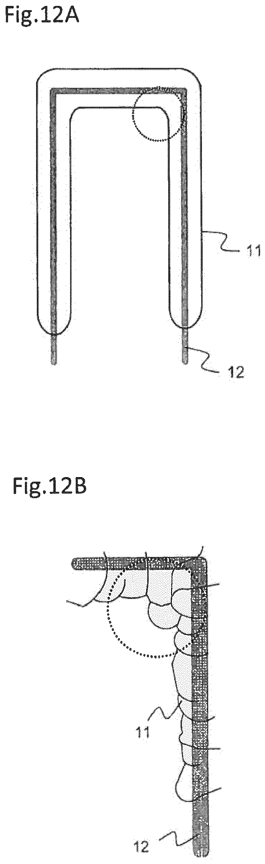

Figure 12A and Figure 12B are views for illustrating a condition in which the crack of the polycrystalline silicon rods occurred, as described above, and an area where the crack occurred is shown by dashed lines.

The inventors, for a cause of such a crack occurrence, believe that occurrence of a so-called "popcorn phenomenon" is responsible for the crack occurrence.

If polycrystalline silicon rods are manufactured using trichlorosilane, a local, excessive crystal growth will occur without a suitable source gas supply dependent on the surface temperature of rods, and the surfaces will be formed in an uneven shape called a "popcorn" shape (see, for example, Patent Literature 3: Japanese Patent Laid-Open No. 55-15999). In the area where the crack occurred, "Popcorn" growth was observed. Also, the popcorn involved a crack-like gap.

That is, it is presumable that the skin effect of the high-frequency current strongly operated locally around the crack-like gap, consequently the polycrystalline silicon melted, resulting in a crack (collapse). It is information no one knows before that such a high-frequency current can locally, excessively heat and damage manufacturing.

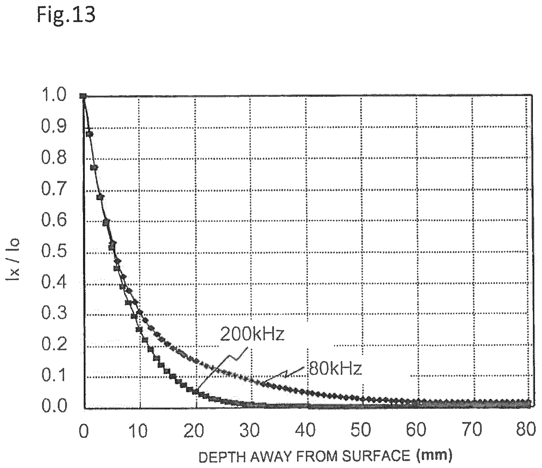

Figure 13 is a view for illustrating a current distribution in a cross-section when current having a frequency of 80 kHz and 200 kHz is applied through a polycrystalline silicon rod having a diameter of 160 mm. Note that the current distribution ($I_X/I_0$) is calculated in a manner as shown in Figure 10B.

As shown in Figure 13, when the current having a frequency of 200 kHz is applied, any current scarcely flows through a region located away by not less than 30 mm from the surface of the polycrystalline silicon rod on the side of the center, and the current concentrates on the side of the surface.

Therefore, generally, a high-frequency current having a frequency of not less than 200 kHz is not suitable for use to electrically heat in the present invention. In other word, when polycrystalline silicon rods having a diameter of more than 160 mm are manufactured, it is necessary for the penetration depth (skin depth) $\delta$ calculated according to the equation above to take a value of at least beyond 13.7 mm. For these reasons, in the present invention, the frequency of a high-frequency current is selected so that the skin depth at which the current flows through polycrystalline silicon rods can take a desired value of not less than 13.8 mm and not more than 80.0 mm.

The penetration depth of the high-frequency current is dependent on the temperature of polycrystalline silicon rods, and to provide the penetration depth in the range above, in the case of 1200°C, the frequency of the current is required to be between 67.2 kHz and 2.0 kHz, in the case of 1 100°C, between 93.7 kHz and 2.8 kHz, in the case of 1000°C, between 137.8 kHz and 4.1 kHz, in the case of 950°C, between 171.1 kHz and 5.1 kHz, and in the case of 900°C, between 216.3 kHz and 6.4 kHz.

Note that to prevent the above popcorn phenomenon from occurring, a sufficient amount of the source gas may be supplied to the surfaces of polycrystalline silicon rods, but as the diameter of the polycrystalline silicon rods increases and the surface areas become wider, the source gas supply tends to be insufficient. Accordingly, after the diameter of polycrystalline silicon rods becomes not less than 130 mm, it is preferable to lower the surface temperature by little and little (S109). For example, when the diameter reaches about 160 mm, the surface temperature is lowered to the range of not less than 950°C and less than 1030°C and if the diameter is further increased, then the surface temperature in the final stage is preferably lowered to the range of 900 and 980°C.

Such a high-frequency current capable of providing the suitable penetration depth may also be used from the initial heating stage of silicon cores prior to the beginning of deposition reaction of polycrystalline silicon rods. However, m silicon cores (m is an integer of 2 or greater) are arranged in the reactor vessel, polycrystalline silicon is deposited on them, and n series-connected polycrystalline silicon rods (n is an integer of 2 or greater and not more than m) whose diameter reaches the predetermined value $D_0$ of not less than 80 mm due to the deposition of polycrystalline silicon may be supplied with a high-frequency current, and before this condition, current having a commercial frequency (low-frequency current) may be used for electric heating.

A power source for applying this high-frequency current may be one high-frequency power source supplying a single high-frequency current, or one variable-frequency, high-frequency power source. Here, "variable-frequency" may be continuously variable or variable step-by-step between a plurality of levels.

Using the variable-frequency, high-frequency power source may offer, for example, the following advantage. To control the surface temperature of polycrystalline silicon rods suitably, it is necessary to increase the amount of energization of polycrystalline silicon rods in response to radial expanding of silicon rods due to progression of the deposition reaction.

However, if the power source to be used has a single frequency, then using a power source having a little higher frequency becomes capable of controlling the total amount of current and provides an economical benefit, but if a power source having a little higher frequency is used, it becomes more difficult to control the penetration depth (skin depth) $\delta$ more suitably by changing a frequency corresponding to the diameter of polycrystalline silicon rods.

In particular, increasing the amount of applied current having some frequency f raises the surface temperature and increases the conductivity (k is increased), accordingly the value of $\delta$ reduces, so that a cyclic process may be created in which the penetration depth (skin depth) $\delta$ reduces, thereby the surface temperature is raised, and therefore, it becomes difficult to control the temperature. Therefore, a trouble such as melting and a crack of silicon rods may easily occur in an area having a shape where the skin effect strongly operates as described above.

And so, a plurality of frequencies of not less than 2 kHz (for example, $f_1$ and $f_2$) may be made ready to be selected, and first, electric heating may be performed using current having the high-frequency $f_1$, and when it becomes necessary to increase the amount of energization in order to maintain the surface temperature, the amount of energization may be increased by switching the current to current having the high-frequency $f_2$ of a little lower than the previous frequency $f_1$. Increasing the amount of energization using the current having a little lower high-frequency $f_2$ as described above can prevent the skin effect from operating too much strongly. Note that such a control of the amount of energization may be performed using current control or voltage control.

Also, if the current having a little lower high-frequency $f_2$ is applied and it is desired to increase a heating value near the surface in order to maintain the surface temperature, then the current is switched to the current having a little higher high-frequency $f_1$ to improve the skin effect, while the amount of energization being kept constant, thereby allowing the heating value near the surfaces to be increased without increasing the amount of energization.

Such a variable range of frequencies is preferably between 2 kHz and 400 kHz, and generally, the larger the number of frequencies continuous or capable of being selected is, the more preferable it is.

For example, if polycrystalline silicon rods having a diameter of about 160 mm whose surface temperature is about 980°C is heated using current having a frequency of 100 kHz and it is desired to raise the surface temperature to about 1000°C by increasing the amount of energization, then the frequency of the current is switched to 80 kHz lower than 100 kHz, the amount of energization is gradually increased by 10A to 50A per step, and it is observed how the temperature goes up. In contrast, if the surface temperature of the polycrystalline silicon rods begins to go down at 80 kHz, the frequency of the current is raised to 100 kHz while maintaining the amount of energization, and if the surface temperature of the polycrystalline silicon rods begins to further go down, the frequency is raised to 120 kHz while maintaining the amount of energization, and so on, then it is observed how the temperature goes up. Even if the operations described above are carried out and the surface temperature begins to go down, then the frequency is lowered to 80 kHz and the amount of energization is gradually increased by 10A to 50A. Controlling the amount of energization and the current frequency alternately in a manner as described above can prevent too strong skin effect from being caused, suppress occurrence of the temperature difference between in the central portions and on the side of polycrystalline silicon rods, and further suppress power consumption efficiently.

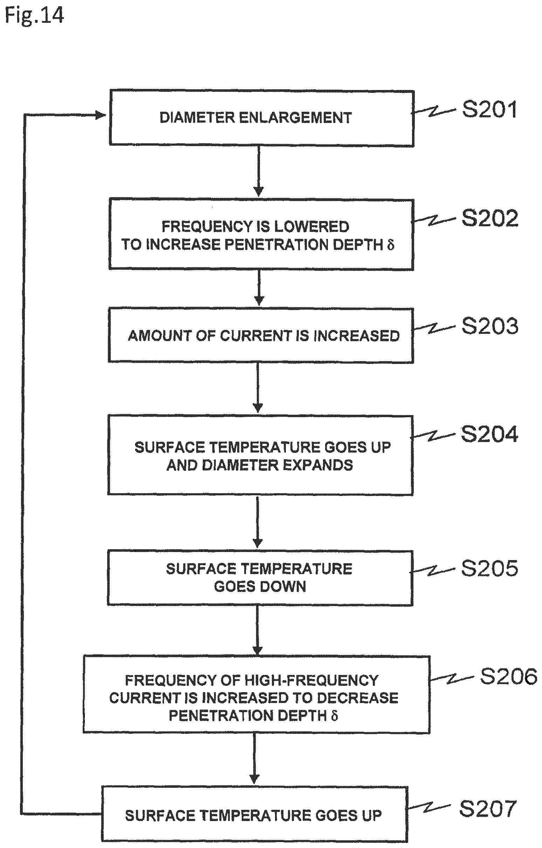

Figure 14 is a flowchart for illustrating a process example for enlarging a diameter of polycrystalline silicon rods while changing the frequency of a high-frequency current involving such a change in amount of energization. As diameter enlargement is promoted (S201), the surface temperature of silicon rods begins to go down. Then, if the amount of energization is increased, resistivity is lowered corresponding to rise in temperature and the penetration depth $\delta$ becomes shallow, accordingly the surface temperature may become too high, thus first, the frequency of the high-frequency current is lowered to increase the penetration depth $\delta$ (S202) and the amount of current is increased (S203). The penetration depth $\delta$ is preliminarily increased in such a manner and the amount of energization is increased safely, thereby raising the surface temperature and enlarging the diameter (S204). If the surface temperature of the silicon rods goes down due to the diameter enlargement (S205), the frequency of the high-frequency current, this time, is increased to decrease the penetration depth $\delta$ (S206), and the surface temperature is raised (S207). After this, it is intended to expand the diameter of the silicon rods while controlling the surface temperature of the polycrystalline silicon rods suitably (S201).

The aforementioned description relates to the growth process of polycrystalline silicon rods, and also it is advantageous to use a high-frequency current in a cooling process after the growth of polycrystalline silicon rods ends.

Similar to the case of using chlorosilanes as a raw material, stresses coming from the temperature difference between on the side of the surfaces and in the central portions tend to accumulate inside of the polycrystalline silicon rods provided through the process in which the deposition temperature is high. Therefore, when such polycrystalline silicon rods are cooled, it is necessary to reduce the temperature difference between on the side of the surfaces and in the central portions to be as small as possible.

For example, in a process after the growth of polycrystalline silicon rods ends, current having a frequency of not less than 2 kHz is applied to heat only on the side of the surfaces slightly, thus cooling so that the temperature difference between on the side of the surfaces and in the central portions is as small as possible till the surfaces of the polycrystalline silicon rods become not more than a predetermined temperature. It is not necessary to separately provide a high-frequency power source for such a cooling process, and the single frequency or variable-frequency, high-frequency power source described above may be used. Note that a frequency of the high-frequency current applied in the cooling process is preferably between not less than 2 kHz and not more than 100 kHz.

Energization in such a cooling process may end at the stage when the surface temperature of polycrystalline silicon rods becomes, for example, not more than 500°C. Note that a rough target for time duration of applying the high-frequency current in the cooling process is preferably about 4 hours, although depending on the diameter or the like.

Traditionally, in manufacturing polycrystalline silicon rods having a large diameter beyond 160 mm, there were problems such as a collapse of polycrystalline silicon rods till the polycrystalline silicon rods were removed from the reacting furnace after growth, and a crack caused by internal, residual stresses even at the stage of working a silicon mass. However, according to the method described above, the polycrystalline silicon rods having small, internal and residual stresses can be provided.

As described above, in the polycrystalline silicon rod manufacturing method according to the present invention, the method includes the high-frequency current applying process for heating polycrystalline silicon rods by applying through the polycrystalline silicon rods the current having a frequency of not less than 2 kHz, the high-frequency current applying process includes supplying n series-connected polycrystalline silicon rods (n is an integer of 2 or greater and not more than m) whose diameter reaches the predetermined value $D_0$ of not less than 80 mm due to the deposition of polycrystalline silicon, with the high-frequency current from one high-frequency power source supplying a single high-frequency current or from one variable-frequency, high-frequency power source, then the frequency of the high-frequency current is set so that the skin depth at which the high-frequency current flows through the n series-connected polycrystalline silicon rods is in the range of not less than 13.8 mm and not more than 80.0 mm.

Examples

Example

Silicon cores 12 made from highly-pure polycrystalline silicon were arranged in a chamber 1 of a reacting furnace 100. After the silicon cores 12 were initially heated to 370°C using a carbon heater 13, a low-frequency current of 50 Hz, i.e. a commercial frequency, having an applied voltage of 2000 V began to be applied through the silicon cores 12.

Deposition reaction of polycrystalline silicon on the silicon cores 12 began with supplying a mixed gas of trichlorosilane used as a source gas with a hydrogen gas, i.e. a carrier gas under conditions in which a voltage of 1050 V was applied to the silicon cores 12 and the surface temperature was 1160°C.

Subsequently, the deposition reaction continued under the condition of energization above till the diameter of the polycrystalline silicon reached 82 mm, subsequently the current was switched to a high-frequency current having a frequency of 80 kHz and it was applied, and the reaction continued till the diameter of the polycrystalline silicon rods reached 163 mm. Note that at the end of the reaction, that is, at the time when the diameter of the polycrystalline silicon rods reached 163 mm, supply power was 363 kW.

After the mixed gas stopped to be supplied and the deposition reaction ended, cooling was carried out by gradually reducing the amount of energization while continuing to apply the high-frequency current having a frequency of 80 kHz till the surface temperature of the polycrystalline silicon rods lowered to 600°C, and subsequently the energization was stopped. The polycrystalline silicon rods 11 were left uncontrolled in the chamber 1 before the surface temperature of the polycrystalline silicon rods 11 became 45°C, and the polycrystalline silicon rods 11 were removed out.

It was observed that any crack did not occur in the obtained polycrystalline silicon rods.

Comparative Example 1

Silicon cores 12 made from highly-pure polycrystalline silicon were arranged in the chamber 1 of the reacting furnace 100. After the silicon cores 12 were initially heated to 340°C using the carbon heater 13, a low-frequency current of 50 Hz, i.e. a commercial frequency, having an applied voltage of 2000 V began to be applied through the silicon cores 12.

Deposition reaction of polycrystalline silicon on the silicon cores 12 began with supplying a mixed gas of trichlorosilane used as a source gas with a hydrogen gas, i.e. a carrier gas under conditions in which a voltage of 1050 V was applied through the silicon cores 12 and the surface temperature was 1130°C.

Subsequently, the deposition reaction continued under the condition of energization above till the diameter of the polycrystalline silicon reached 80 mm, also subsequently, the low-frequency current having a frequency of 50 Hz continued to be applied, and the reaction continued till the diameter of the polycrystalline silicon rods reached 156 mm. Note that at the end of the reaction, that is, at the time when the diameter of the polycrystalline silicon rods reached 156 mm, supply power was 428 kW.

After the mixed gas stopped to be supplied and the deposition reaction ended, cooling was carried out by gradually reducing the amount of energization while continuing to apply the low-frequency current having a frequency of 50 Hz till the surface temperature of the polycrystalline silicon rods lowered to 600°C, and subsequently the energization was stopped.

In this cooling process, the polycrystalline silicon rods 11 collapsed in the chamber 1. It is presumable that a cause of the collapse is occurrence of cracks.

Comparative Example 2

Silicon cores 12 made from highly-pure polycrystalline silicon were arranged in the chamber 1 of the reacting furnace 100. After the silicon cores 12 were initially heated to 355°C using the carbon heater 13, a low-frequency current of 50 Hz, i.e. a commercial frequency, having an applied voltage of 2000 V began to be applied through the silicon cores 12.

Deposition reaction of polycrystalline silicon on the silicon cores 12 began with supplying a mixed gas of trichlorosilane used as a source gas with a hydrogen gas, i.e. a carrier gas, under conditions in which a voltage of 1010 V was applied to the silicon cores 12 and the surface temperature was 1100°C.

Subsequently, the deposition reaction continued under the condition of energization above till the diameter of the polycrystalline silicon reached 80 mm, also subsequently, the low-frequency current having a frequency of 50 Hz continued to be applied, thus expanding the diameter. When the polycrystalline silicon rods reached 159 mm, they collapsed. Note that when the polycrystalline silicon rods reached 159 mm, supply power was 448 kW.

It is similarly presumable that a cause of the collapse of the polycrystalline silicon rods 11 is occurrence of cracks.

The polycrystalline silicon rod manufacturing method according to the present invention has been described above, and the disclosed invention now will be organized again as follows.

If a high-frequency power source supplying a single high-frequency current is used, the polycrystalline silicon rod manufacturing method according to the present invention may include a configuration described below.

In a process in which m silicon cores (m is an integer of 2 or greater) are arranged in a reactor vessel, a source gas containing silane compounds is supplied into a reacting furnace, and polycrystalline silicon is deposited on the silicon cores electrically heated using the CVD method to manufacture polycrystalline silicon rods, a high-frequency current applying process is provided in which the polycrystalline silicon rods are heated by applying through the polycrystalline silicon rods a current having a frequency of not less than 2 kHz. This high-frequency current applying process includes a process in which n polycrystalline silicon rods (n is an integer of 2 or greater and not more than m) whose diameter reaches a predetermined value $D_0$ of not less than 80 mm due to the deposition of polycrystalline silicon are connected to each other in series, and the n series-connected polycrystalline silicon rods are supplied with a high-frequency current from one high-frequency power source supplying a single high-frequency current. In the high-frequency current applying process, the frequency of the high-frequency current is set so that the skin depth at which the high-frequency current flows through the n series-connected polycrystalline silicon rods takes a desired value in the range of not less than 13.8 mm and not more than 80.0 mm.

If a variable-frequency, high-frequency power source is used, the polycrystalline silicon rod manufacturing method according to the present invention may include a configuration described below.

The high-frequency current applying process described above includes a process in which n polycrystalline silicon rods (n is an integer of 2 or greater and not more than m) whose diameter reaches a predetermined value $D_0$ of not less than 80 mm due to the deposition of polycrystalline silicon are connected to each other in series, and the n series-connected polycrystalline silicon rods are supplied with a high-frequency current from one variable-frequency, high-frequency power source, and the frequency of the high-frequency current is changed in response to variation in surface temperature of the polycrystalline silicon rods to the extent that the skin depth at which the high-frequency current flows through the n series-connected polycrystalline silicon rods takes a desired value in the range of not less than 13.8 mm and not more than 80.0 mm.

In every one of these aspects, the silicon cores may begin to be heated by applying through the silicon cores the low-frequency current or the high-frequency current, and after the surfaces of the silicon cores become a desired temperature, polycrystalline silicon may begin to be deposited.

At this time, m silicon cores may be connected to each other in parallel, and the silicon cores may begin to be heated by supplying the parallel-connected silicon cores with current from one low-frequency power source supplying a low-frequency current.

Also, m silicon cores may be connected to each other in series in order from a first one to an m-th, and the silicon cores may begin to be heated by supplying the series-connected silicon cores with current from one low-frequency power source or from one high-frequency power source.

In the polycrystalline silicon rod manufacturing method according to the present invention, in an aspect, from when polycrystalline silicon begins to be deposited until the diameter of the polycrystalline silicon rods reaches a predetermined value $D_0$, m polycrystalline silicon rods may be connected to each other in parallel, and the polycrystalline silicon rods may be heated by supplying the parallel-connected polycrystalline silicon rods with current from one low-frequency power source supplying a low-frequency current.

Also, in an aspect, M silicon cores (M is an integer of 2 or greater) may be further arranged in the reactor vessel, and polycrystalline silicon may be deposited on the M silicon cores in a similar manner as that of the deposition of polycrystalline silicon on the m silicon cores, using a high-frequency power source provided separately from the one high-frequency power source and supplying a single high-frequency current having a frequency of not less than 2 kHz, or one variable-frequency, high-frequency power source supplying current having a frequency of not less than 2 kHz.

Further, according to the present invention a gas containing trichlorosilane is selected as a source gas, and the surface temperature of polycrystalline silicon rods is controlled in the range of not less than 900°C and not more than 1250°C to deposit polycrystalline silicon.

Industrial Applicability

As described above, the present invention provides technologies for manufacturing polycrystalline silicon rods having a large diameter with a high efficiency while using trichlorosilane as a raw material and preventing a collapse that easily occurs when the polycrystalline silicon rods having a large diameter are manufactured.

Reference Signs List

| 1 | bell jar (chamber) |
| 2 | observation window |
| 3 | cooling medium inlet (bell jar) |
| 4 | cooling medium outlet (bell jar) |
| 5 | base plate |
| 6 | cooling medium inlet (base plate) |
| 7 | cooling medium outlet (base plate) |
| 8 | reaction exhaust gas outlet |
| 9 | source gas supply nozzle |
| 10 | electrode |
| 11 | polycrystalline silicon rod |
| 12 | silicon core |
| 13 | carbon heater |
| 14 | core holder |
| 15L, H, C | power source |
| 16 | series/parallel switching circuit |
| 100 | reacting furnace |
| 151 | power receiving component |
| 152 | air circuit breaker (ACB) |
| 153 | power source transformer |
| 154 | output control component |
| 155 | output component |
| 156 | output transformer |
| 157 | frequency converter |

Claims

1. A polycrystalline silicon rod manufacturing method wherein m silicon cores, m being an integer of 2 or greater, are arranged in a reactor vessel, a source gas containing trichlorosilane is supplied into the reactor vessel, and polycrystalline silicon is deposited on the silicon cores electrically heated using a CVD method, to obtain polycrystalline silicon rods having a diameter not less than 160mm,

the method comprising a high-frequency current applying process for heating the polycrystalline silicon rods by applying through the polycrystalline silicon rods a current having a frequency of not less than 2 kHz,
wherein the high-frequency current applying process comprises supplying a high-frequency current from one high-frequency power source supplying a single high-frequency current to n polycrystalline silicon rods, n being an integer of 2 or greater and not more than m, connected to each other in series whose diameter reaches a predetermined value $D_0$ of not less than 80mm due to the deposition of polycrystalline silicon, and
a frequency of the high-frequency current is set so that a skin depth at which the high-frequency current flows through the n series-connected polycrystalline silicon rods takes a desired value in the range of not less than 13.8 mm and not more than 80.0 mm,
wherein a surface temperature of the polycrystalline silicon rods is controlled in a range of not less than 900°C and not more than 1250°C to deposit polycrystalline silicon;
the method further comprising:

a process to heat the silicon cores by applying a current through the silicon cores before the high-frequency current applying process, and
a process to commence a deposition of polycrystalline silicon on surfaces of the silicon cores after the surfaces of the silicon cores become a desired temperature; and wherein the m silicon cores are connected to each other in parallel before the process to heat the silicon cores,

then current from one low-frequency power source supplies a low-frequency current to the m silicon cores, and

when the diameter of the m polycrystalline silicon rods reaches the predetermined value $D_0$, the m polycrystalline silicon rods are switched to be connected to each other in series, and the high-frequency current applying process is performed by supplying the high-frequency current from the one high-frequency power source.

2. The polycrystalline silicon rod manufacturing method according to claim 1, wherein

M silicon cores, M being an integer of 2 or greater, are further arranged in the reactor vessel, and

polycrystalline silicon is deposited on the M silicon cores in a similar manner as that for depositing polycrystalline silicon on the m silicon cores, using a high-frequency power source provided separately from the one high-frequency power source and supplying a single high-frequency current having a frequency of not less than 2 kHz.

**Patentansprüche**

1. Herstellungsverfahren für einen polykristallinen Siliziumstab, wobei m Siliziumkerne, wo m eine ganze Zahl von 2 oder größer ist, in einem Reaktorgefäß angeordnet werden, ein Quellengas, das Trichlorsilan enthält, in das Reaktorgefäß zugeführt wird und polykristallines Silizium an den Siliziumkernen, die elektrisch erhitzt werden, unter Verwendung eines CVD-Verfahrens abgeschieden wird, um polykristalline Siliziumstäbe zu erhalten, die einen Durchmesser von nicht kleiner als 160 mm aufweisen,

das Verfahren einen Hochfrequenzstrom-Anwendungsvorgang zum Erhitzen der polykristallinen Siliziumstäbe durch Anlegen durch die polykristallinen Siliziumstäbe eines Stroms umfasst, der eine Frequenz von nicht kleiner als 2 kHz aufweist,

wobei der Hochfrequenzstrom-Anwendungsvorgang die Zuführung eines Hochfrequenzstroms von einer Hochfrequenzstromquelle umfasst, die einen einzelnen Hochfrequenzstrom zu n polykristallinen Siliziumstäben zuführt, wo n eine ganze Zahl von 2 oder größer und nicht mehr als m ist, die miteinander in Reihe verbunden sind, deren Durchmesser einen vorgegebenen Wert $D_0$ von nicht kleiner als 80 mm aufgrund der Abscheidung von polykristallinem Silizium erreicht, und

eine Frequenz des Hochfrequenzstroms derart eingestellt ist, dass eine Eindringtiefe, in die der Hochfrequenzstrom durch die n in Reihe verbundenen polykristallinen Siliziumstäbe fließt, einen gewünschten Wert in dem Bereich von nicht kleiner als 13,8 mm und nicht größer als 80,0 mm einnimmt,

wobei eine Oberflächentemperatur der polykristallinen Siliziumstäbe in einem Bereich von nicht kleiner als 900 °C und nicht größer als 1250 °C gesteuert wird, um polykristallines Silizium abzuscheiden;

wobei das Verfahren weiter Folgendes umfasst:

einen Vorgang des Erhitzens der Siliziumkerne durch Anwenden eines Stroms durch die Siliziumkerne vor dem Hochfrequenzstrom-Anwendungsvorgang und

einen Vorgang des Startens einer Abscheidung von polykristallinem Silizium auf Oberflächen der Siliziumkerne, nachdem die Oberflächen der Siliziumkerne eine gewünschte Temperatur aufweisen; und

wobei die m Siliziumkerne vor dem Vorgang des Erhitzens der Siliziumkerne miteinander parallel verbunden sind,

dann ein Strom von einer Niederfrequenzstromquelle einen Niederfrequenzstrom zu den m Siliziumkernen zuführt, und

wenn der Durchmesser der m polykristallinen Siliziumstäbe den vorgegebenen Wert $D_0$ erreicht, die m polykristallinen Siliziumstäbe zur Verbindung miteinander in Reihe umgeschaltet werden und der Hochfrequenzstrom-Anwendungsvorgang durch Zuführen des Hochfrequenzstroms von der einen Hochfrequenzstromquelle durchgeführt wird.

2. Herstellungsverfahren für einen polykristallinen Siliziumstab nach Anspruch 1, wobei M Siliziumkerne, wo M eine ganze Zahl von 2 oder größer ist, weiter in dem Reaktorgefäß angeordnet werden und polykristallines Silizium auf den M Siliziumkernen in einer ähnlichen Weise wie die zur Abscheidung von polykristallinem Silizium auf den m Siliziumkernen unter Verwendung einer Hochfrequenzstromquelle abgeschieden wird, die separat von der einen Hochfrequenzstromquelle bereitgestellt wird und einen einzelnen Hochfrequenzstrom zuführt, der eine Frequenz von nicht kleiner als 2 kHz aufweist.

**Revendications**

1. Méthode de fabrication de bâtonnets de silicium polycristallin, dans laquelle m coeurs de silicium, m étant un nombre entier valant 2 ou plus, sont disposés dans une cuve de réacteur, un gaz source contenant du trichlorosilane est amené dans la cuve de réacteur, et du silicium polycristallin est déposé sur les coeurs de silicium chauffés électriquement par une technique CVD, afin d'obtenir des bâtonnets de silicium polycristallin ayant un diamètre non inférieur à 160 mm,

   la méthode comprenant un procédé d'application de courant à haute fréquence pour chauffer les bâtonnets de silicium polycristallin en appliquant, à travers les bâtonnets de silicium polycristallin, un courant ayant une fréquence non inférieure à 2 kHz,
   dans lequel le procédé d'application de courant à haute fréquence consiste à fournir un courant à haute fréquence à partir d'une source d'énergie à haute fréquence unique fournissant un seul courant à haute fréquence à n bâtonnets de silicium polycristallin, n étant un nombre entier valant de 2 ou plus et pas plus de m, connectés les uns aux autres en série et dont le diamètre atteint une valeur prédéterminée $D_0$ non inférieure à 80 mm en raison du dépôt de silicium polycristallin, et
   une fréquence du courant à haute fréquence est réglée de telle sorte qu'une profondeur de pénétration à laquelle le courant à haute fréquence circule à travers les n bâtonnets de silicium polycristallin connectés en série prenne une valeur souhaitée dans une plage non inférieure à 13,8 mm et non supérieure à 80,0 mm,
   où une température de surface des bâtonnets de silicium polycristallin est contrôlée dans une plage non inférieure à 900°C et non supérieure à 1250°C pour déposer du silicium polycristallin ;
   la méthode comprenant en outre :

   un procédé pour chauffer les coeurs de silicium en appliquant un courant à travers les coeurs de silicium avant le procédé d'application de courant à haute fréquence, et
   un procédé pour commencer un dépôt de silicium polycristallin sur les surfaces des coeurs de silicium une fois que les surfaces des coeurs de silicium ont atteint une température souhaitée ; et
   où les m coeurs de silicium sont connectés les uns aux autres en parallèle avant le procédé de chauffage des coeurs de silicium, puis le courant provenant d'une source d'énergie à basse fréquence unique fournit un courant à basse fréquence aux m coeurs de silicium, et
   lorsque le diamètre des m bâtonnets de silicium polycristallin atteint la valeur prédéterminée $D_0$, les m bâtonnets de silicium polycristallin sont commutés pour être connectés les uns aux autres en série, et le procédé d'application de courant à haute fréquence est mis en oeuvre par la fourniture du courant à haute fréquence à partir de la source d'énergie à haute fréquence unique.

2. Méthode de fabrication de bâtonnets de silicium polycristallin selon la revendication 1, dans laquelle

   M coeurs de silicium, M étant un nombre entier valant 2 ou plus, sont en outre disposés dans la cuve de réacteur, et
   du silicium polycristallin est déposé sur les M coeurs de silicium d'une manière similaire à celle du dépôt de silicium polycristallin sur les m coeurs de silicium, en utilisant une source d'énergie à haute fréquence fournie séparément de la source d'énergie à haute fréquence unique et en fournissant un seul courant à haute fréquence ayant une fréquence non inférieure à 2 kHz.

EP 2 818 450 B1

Fig.1

18

Fig.2

Fig.3A

Fig.3B

Fig.4A

Fig.4B

Fig.5A

Fig.5B

Fig.6A

## Fig.6B

Fig.7A

Fig.7B

Fig.7C

Fig.8A

Fig.8B

Fig.8C

Fig.9

REPLACED WITH NITROGEN INSIDE OF CHAMBER — S101

REPLACED WITH HYDROGEN INSIDE OF CHAMBER — S102

SILICON CORES ARE INITIALLY HEATED — S103

SILICON CORES ARE HEATED ON A FULL SCALE — S104

COMMENCEMENT OF VAPOR PHASE REACTION — S105

GAS SUPPLY CONDITIONS IN EARLY STAGE OF VAPOR PHASE REACTION — S106

GAS SUPPLY CONDITIONS AFTER EARLY STAGE OF VAPOR PHASE REACTION — S107

GAS SUPPLY CONDITIONS ARE CHANGED — S108

SURFACE TEMPERATURE OF POLYCRYSTALLINE SILICON RODS IS GRADUALLY LOWERED — S109

Fig.10A

Fig.10B

Fig.11

**Fig.12A**

**Fig.12B**

Fig.13

Fig.14

```
┌─────────────────────────────┐
│    DIAMETER ENLARGEMENT     │ ⟿ S201
└─────────────────────────────┘
              │
              ▼
┌─────────────────────────────┐
│    FREQUENCY IS LOWERED      │ ⟿ S202
│ TO INCREASE PENETRATION DEPTH δ │
└─────────────────────────────┘
              │
              ▼
┌─────────────────────────────┐
│ AMOUNT OF CURRENT IS INCREASED │ ⟿ S203
└─────────────────────────────┘
              │
              ▼
┌─────────────────────────────┐
│ SURFACE TEMPERATURE GOES UP │ ⟿ S204
│    AND DIAMETER EXPANDS      │
└─────────────────────────────┘
              │
              ▼
┌─────────────────────────────┐
│    SURFACE TEMPERATURE       │ ⟿ S205
│       GOES DOWN             │
└─────────────────────────────┘
              │
              ▼
┌─────────────────────────────┐
│  FREQUENCY OF HIGH-FREQUENCY │ ⟿ S206
│ CURRENT IS INCREASED TO DECREASE │
│    PENETRATION DEPTH δ       │
└─────────────────────────────┘
              │
              ▼
┌─────────────────────────────┐
│ SURFACE TEMPERATURE GOES UP │ ⟿ S207
└─────────────────────────────┘
```

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 63074909 A
- WO 2002508294 A
- US 6221155 B1
- JP 55015999 A